# EUROPEAN PATENT SPECIFICATION

(11) **EP 3 345 218 B1**
(45) Date of publication and mention of the grant of the patent: **25.06.2025**
(21) Application number: 16751137.7
(22) Date of filing: 08.08.2016
(51) Int. Cl.: H01L 23/64, H01L 23/498

(54) **INTEGRATION OF INDUCTORS WITH ADVANCED-NODE SYSTEM-ON-CHIP (SOC) USING GLASS WAFER WITH INDUCTORS AND WAFER-TO-WAFER JOINING**
INTEGRATION VON INDUKTOREN MIT EINEM SYSTEM-ON-CHIP (SOC) MIT ERWEITERTEM KNOTEN UNTER VERWENDUNG VON GLASWAFERN MIT INDUKTOREN UND VERBINDUNG VON WAFER ZU WAFER
INTÉGRATION D'INDUCTEURS AVEC UN SYSTÈME SUR PUCE (SOC) À NOEUD AVANCÉ AU MOYEN DE PLAQUETTES EN VERRE COMPORTANT DES INDUCTEURS ET UNE LIAISON PLAQUETTE À PLAQUETTE

(30) Priority: 02.09.2015 US 201514843964
(43) Date of publication of application: 11.07.2018
(73) Proprietor: Qualcomm Incorporated, San Diego, CA 92121-1714 (US)
(72) Inventor: ARABI, Karim, San Diego, California 92121-1714 (US); SHENOY, Ravindra Vaman, San Diego, California 92121-1714 (US); GOUSEV, Evgeni Petrovich, San Diego, California 92121-1714 (US); ERTURK, Mete, San Diego, California 92121-1714 (US)
(74) Representative: Jaeger, Michael David
(86) International application number: PCT/US2016/045998
(87) International publication number: WO 2017/039962

(56) References cited:
- US-A1- 2002 095 768
- US-A1- 2006 088 971
- US-A1- 2013 113 448
- US-A1- 2015 137 342
- US-B1- 7 463 131

## Description

### Field of Disclosure

Various embodiments described herein relate to integrated circuit devices, and more particularly, to integrated circuit devices with voltage regulators.

### Background

Voltage regulators have been implemented in conventional dedicated power management integrated circuits (PMICs). A conventional PMIC, which is separate from other integrated circuits on a circuit board, may have difficulty meeting the droop (transient) and power (efficiency) requirements of a modern multi-core application processor or communication processor, for example.

There has been a growing interest in integrating voltage regulators as part of system-on-chip (SOC) integrated circuit devices. Integrated voltage regulators, however, may present several challenges in chip design and layout. For example, passive components such as inductors and capacitors in voltage regulators may pose a design challenge, because passive components, such as inductors and capacitors, especially those with large inductance and capacitance values, typically have large form factors requiring large surface areas in a typical layout for a silicon SOC die.

Moreover, inductors in voltage regulators typically require very low resistances to minimize power losses in voltage regulation. In addition to occupying a significant amount of surface area of a typical silicon SOC die, such inductors may require thick metal traces on the SOC die in order to reduce the resistance values of the inductors. In advanced-node SOC wafer fabrication, however, such thick metal traces may not be feasible. Moreover, even if thick metal traces are implementable on a silicon SOC die, conventional fabrication processes for integrating inductors as part of a voltage regulator on a silicon SOC die may require several additional masks, thereby increasing the cost of fabrication.
US 2013/113448 A1 describes a structure and method of making a coil inductor on a semiconductor chip, on an interconnection device, or on a plurality of stacked semiconductor chips. US 2015/137342 A1 relates to systems and methods for providing
inductor structures external to an integrated circuit. US 2015/137342 A1 discloses a semiconductor device comprising a system-on-chip wafer joined to an inductor wafer, but is silent about a magnetic layer and about an integrated voltage regulator. US 2002/095768 Al relates to
inductors used with integrated circuits, and discloses that inductance can be increased by combining a magnetic layer and a conductive layer on the magnetic layer with a dielectric layer there between .

### SUMMARY

Exemplary embodiments of the disclosure are directed to integrated circuit devices and methods of making the same. In accordance with the present invention, there is provided a device as set out in claim 1 and a method of making a device as set out in claim 7.
Other aspects of the invention can be found in the dependent claims.

### BRIEF DESCRIPTION OF THE DRAWINGS

The accompanying drawings are presented to aid in the description of embodiments of the disclosure and are provided solely for illustration of the embodiments and not limitation thereof.
FIG. 1 is a perspective view illustrating an embodiment of a system-on-chip (SOC) wafer.
FIG. 2 is a perspective view illustrating an embodiment of an inductor wafer with through vias.
FIG. 3 is a perspective view illustrating an embodiment of face-to-face wafer-to-wafer bonding of an SOC wafer and an inductor wafer.
FIG. 4 is a sectional view illustrating an embodiment of a first process step in the manufacturing of an inductor on an inductor wafer with through vias.
FIG. 5 is a sectional view illustrating an embodiment of a second process step in the manufacturing of the inductor with a patterned thin-film magnetic layer.
FIG. 6 is a sectional view of an embodiment of a third process step in the manufacturing of the inductor with a dielectric on the thin-film magnetic layer.
FIG. 7 is a sectional view of an embodiment of a fourth process step in the manufacturing of the inductor with metal plating.
FIG. 8 is a top plan view of an inductor having a coil with multiple loops.
FIG. 9 is a sectional view illustrating an embodiment of a fifth process step in the manufacturing of a system-on-chip (SOC) device by joining an SOC wafer with an inductor wafer.
FIG. 10 is a sectional view illustrating an embodiment of the SOC device of FIG. 9 after the SOC wafer and the inductor wafer are joined together.
FIG. 11 is a perspective view illustrating an embodiment of an inductor die after dicing of the joined SOC wafer and inductor wafer.
FIG. 12 is a sectional view illustrating an embodiment of a system including a printed circuit board (PCB), an SOC package, and a voltage regulator which includes an inductor die.
FIG. 13 is a diagram illustrating am embodiment of a system including a power management integrated circuit (PMIC) and an SOC device which includes an integrated or embedded voltage regulator and circuit using the voltage regulator.

### DETAILED DESCRIPTION

Aspects of the disclosure are described in the following description and related drawings directed to specific embodiments. Alternate embodiments may be devised. Additionally, well-known elements will not be described in detail or will be omitted so as not to obscure the relevant details of the disclosure.

The word "exemplary" is used herein to mean "serving as an example, instance, or illustration." Any embodiment described herein as "exemplary" is not necessarily to be construed as preferred or advantageous over other embodiments. Likewise, the term "embodiments" does not require that all embodiments include the discussed feature, advantage or mode of operation.

The terminology used herein is for the purpose of describing particular embodiments only and is not intended to be limiting of the embodiments. As used herein, the singular forms "a," "an" and "the" are intended to include the plural forms as well, unless the context clearly indicates otherwise. It will be further understood that the terms "comprises," "comprising," "includes" or "including," when used herein, specify the presence of stated features, integers, steps, operations, elements, and/or components, but do not preclude the presence or addition of one or more other features, integers, steps, operations, elements, components, or groups thereof. Moreover, it is understood that the word "or" has the same meaning as the Boolean operator "OR," that is, it encompasses the possibilities of "either" and "both" and is not limited to "exclusive or" ("XOR"), unless expressly stated otherwise. It is also understood that the symbol "/" between two adjacent words has the same meaning as "or" unless expressly stated otherwise. Moreover, phrases such as "connected to," "coupled to" or "in communication with" are not limited to direct connections unless expressly stated otherwise.

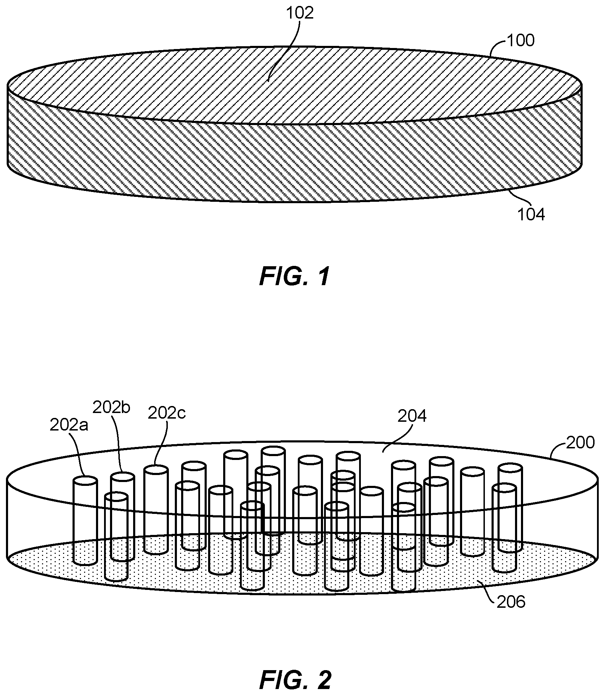

FIG. 1 is a perspective view illustrating an embodiment of a system-on-chip (SOC) wafer 100 having a first surface 102 and a second surface 104 opposite each other. In an embodiment, the SOC wafer 100 comprises a semiconductor wafer, such as a silicon wafer. In alternate embodiments, the SOC wafer 100 may comprise a glass wafer, a quartz wafer, an organic wafer, or a wafer made of another material. In the embodiments, the SOC wafer 100 is integrated with an inductor wafer on which one or more inductors are provided.

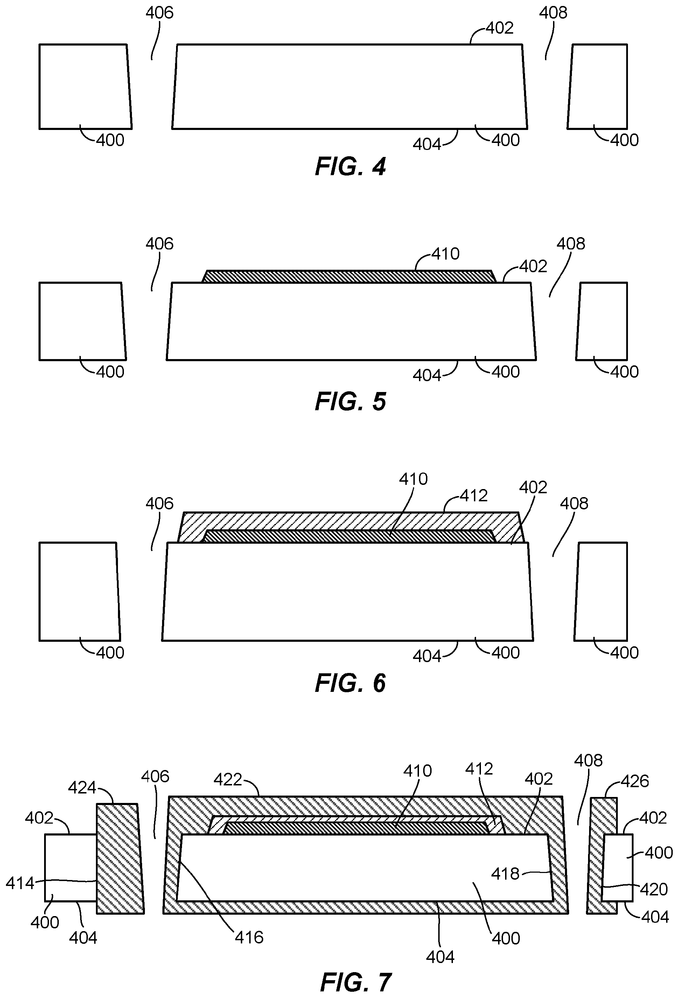

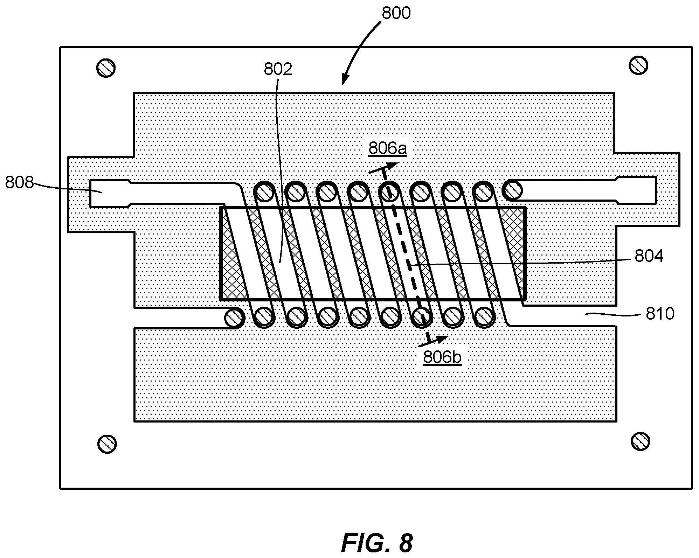

FIG. 2 is a perspective view illustrating an embodiment of an inductor wafer 200 with a plurality of through vias 202a, 202b, 202c, .... In the embodiment illustrated in FIG. 2, the inductor wafer 200 has first and second surfaces 204 and 206 opposite each other, and the vias 202a, 202b, 202c, ... are formed through the first and second surfaces 204 and 206 of the inductor wafer 200. In an embodiment, the inductor wafer 200 comprises a glass wafer. In alternate embodiments, the inductor wafer 200 may comprise a quartz wafer, an organic wafer, or another type of low-loss dielectric material, to ensure that the inductor fabricated on the inductor wafer 200 has a low parasitic loss. For simplicity of illustration, detailed structure of the conductors in the vias 202a, 202b, 202c, ... and the patterned conductive layers on the first and second surfaces 204 and 206 of the inductor wafer 200 which form one or more coils of an integrated inductor are not shown in the perspective view of FIG. 2. Embodiments of the integrated inductor formed on the inductor wafer 200 will be described in further detail below with respect to FIGs. 4-7 and the top plan view of FIG. 8.

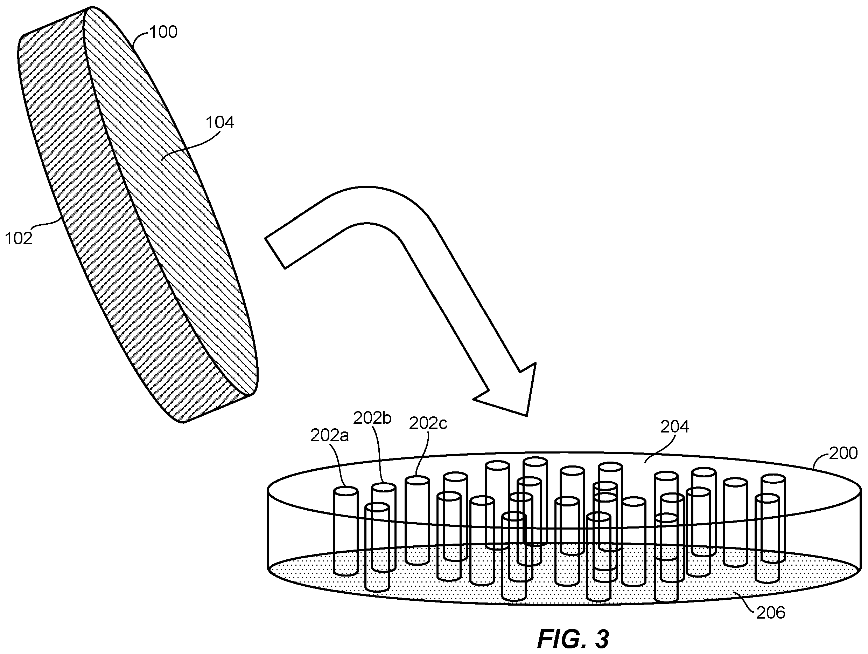

FIG. 3 is a perspective view illustrating an embodiment of face-to-face wafer-to-wafer bonding of the SOC wafer 100 and the inductor wafer 200. In this embodiment, the second surface 104 of the SOC wafer 100 is joined with the first surface 204 of the inductor wafer 200. Again, detailed structure of the integrated inductor formed on the inductor wafer 200 is omitted in FIG. 3 for simplicity of illustration. Embodiments of the integrated inductor formed on the inductor wafer 200 will be described with respect to FIGs. 4-8.

FIG. 4 is a sectional view illustrating an embodiment of a first process step in the manufacturing of an inductor on an inductor wafer with through vias. In FIG. 4, an inductor wafer 400 having a first surface 402 and a second surface 404 is provided. The inductor wafer 400 may be a glass wafer, a quartz wafer, or another type of wafer made of a low-loss dielectric material, for example. In the embodiment shown in FIG. 4, first and second vias 406 and 408 are formed within the inductor wafer 400 through the first and second surfaces 402 and 404.

FIG. 5 is a sectional view illustrating an embodiment of a second process step in the manufacturing of the inductor with a magnetic layer. In FIG. 5, a magnetic layer, such as a patterned thin-film magnetic layer 410, is formed on the first surface 402 of the inductor wafer 400. In the embodiment illustrated in FIG. 5, the patterned thin-film magnetic layer 410 is formed on the first surface 402 of the portion of the inductor wafer 400 between the first and second vias 406 and 408.

The patterned thin-film magnetic layer 410 may be fabricated in various manners. For example, a magnetic material, such as cobalt-tantalum-zirconium (CoTaZr), may be deposited by vacuum processes, plated, screen-printed, or laminated onto the first surface 402 of the inductor wafer 400 to form the thin-film magnetic layer 410. Other magnetic materials, such as alloys of nickel-iron (NiFe), cobalt-iron (CoFe), or cobalt-nickel-iron (CoNiFe), with added materials such as phosphorus (P), boron (B) or carbon (C), may be used for the patterned thin-film magnetic layer 410 to tailor the magnetic and electrical properties of the patterned thin-film magnetic layer 410. In an embodiment, the magnetic material for the patterned thin-film magnetic layer 410 is chosen so as to enable a boost in the inductance value of the inductor at the appropriate operating frequencies. Other types of magnetic materials may also be implemented as the patterned thin-film magnetic layer 410. The magnetic layer 410 may also be formed by other techniques, for example, by sputtering a magnetic material on the first surface 402 of the inductor wafer 400.

FIG. 6 is a sectional view of an embodiment of a third process step in the manufacturing of the inductor with a dielectric on the patterned thin-film magnetic layer. In FIG. 6, a dielectric layer 412 is formed on top of the patterned thin-film magnetic layer 410. In the embodiment illustrated in FIG. 6, the dielectric layer 412 covers the entire top and side surfaces of the thin-film magnetic layer 410, as well as portions of the first surface 402 of the inductor wafer 400 surrounding the patterned thin-film magnetic layer 410. In an embodiment, the dielectric layer 412 comprises a polymer dielectric material. In an alternate embodiment, the dielectric layer 412 comprises an inorganic dielectric material, for example, silicon dioxide (SiO₂). Other types of dielectric materials may also be used for the dielectric layer 412 within the scope of the disclosure.

FIG. 7 is a sectional view of an embodiment of a fourth process step in the manufacturing of the inductor with metal plating. In the sectional view shown in FIG. 7, the first via 406 has sidewalls 414 and 416, and likewise, the second via 408 has sidewalls 418 and 420 between the first and second surfaces 402 and 404 of the inductor wafer 400. In an embodiment, a conductive layer 422 is formed on the dielectric layer 412, on the sidewall 416 of the first via 406, on the sidewall 418 of the second via 408, and on the second surface 404 of the inductor wafer 400 between the first and second vias 406 and 408. In an embodiment, the conductive layer 422 is formed by metal plating.

In a further embodiment, the conductive layer is formed by semi-additive plating of a metal such as copper (Cu). In the sectional view shown in FIG. 7, the sidewall 414 opposite the sidewall 416 the first via 406 and at least portions of the first and second surfaces 402 and 404 of the inductor wafer 400 adjacent to the sidewall 414 are also covered by a conductive layer 424. Likewise, as shown in FIG. 7, the sidewall 420 opposite the sidewall 418 the second via 408 and at least portions of the first and second surfaces 402 and 404 of the inductor wafer 400 adjacent to the sidewall 420 are also covered by a conductive layer 426. Similar to the conductive layer 422, the conductive layers 424 and 426 may also be formed by metal plating, such as semi-additive copper plating.

In the embodiment illustrated in the sectional view of FIG. 7, the conductive layer 422 is shown as a section of one loop of an inductor coil which comprises a plurality of loops. A top plan view of an embodiment of a solenoid inductor which comprises an inductor coil with multiple loops is shown in FIG. 8, which will be described in further detail below. Other inductor topologies, for example, spiral inductors, toroid inductors, or racetrack inductors, may also be implemented instead of the solenoid inductor in the embodiments described and illustrated herein. In an SOC package with a limited amount of space, however, a solenoid inductor may be chosen for its small footprint and easy, efficient integration closest to the circuitry on the SOC die.

Referring to the embodiment shown in FIG. 7, the conductive layer 422, which is illustrated as the sectional view of one loop of coil of an inductor, surrounds the thin-film magnetic layer 410, which is implemented as a magnetic core of the inductor. In an alternate embodiment, another magnetic layer may be provided within the inductor coil, for example, a magnetic layer formed on the second surface 404 of the inductor wafer 400 opposite the magnetic layer 410 as shown in FIG. 7, to increase the overall magnetic flux and thus the overall inductance of the inductor. In an example not forming part of the present invention but useful for understanding, an inductor with multiple loops of coil, with each loop having a sectional view similar to the sectional view of the conductive layer 422 as shown in FIG. 7, may be provided without any magnetic layer inside the coil, although such an inductor with no magnetic core would have a lower inductance compared to an inductor of the same size and the same number of loops having one or more magnetic cores.

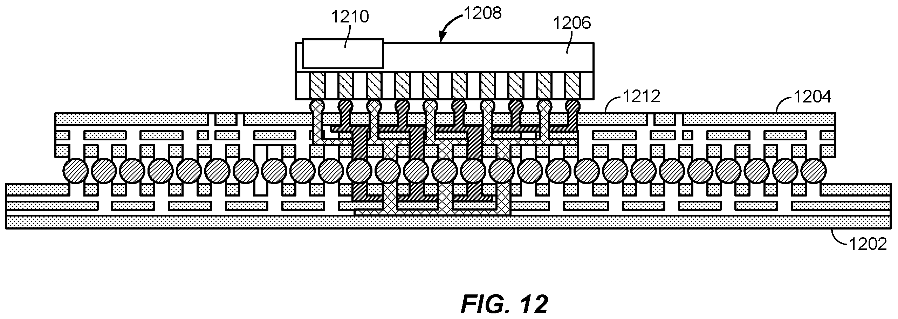

FIG. 8 is a top plan view of an inductor 800 having a coil 802 with multiple loops before the SOC wafer is joined with the inductor wafer. In an embodiment, a sectional view of one of the loops 804 taken along sectional line 806a-806b is illustrated in FIG. 7. Referring to the top plan view of FIG. 8, the inductor 800 has two terminals 808 and 810 at two opposite ends of the coil 802 for electrical connections with other circuit components in a voltage regulator. In the embodiments, some of the pass-through vias in the inductor wafer 400, like the first via 406 and the second via 408 as illustrated in FIGs. 4-7, are used to form electrical connections between die pads on the SOC die and pads on the substrate. For example, some of the pass-through vias may be connected to enable power supply connections and/or to provide ground planes to improve power delivery to the SOC die. In an embodiment, the conductive layer 422, which may comprise a thick Cu plating on the inductor wafer 200, can be used as an additional routing layer to improve the performance of an advanced node SOC device with an advanced node SOC wafer 100. In a further embodiment, by using a combined design of the advanced node SOC wafer 100, the inductor wafer 200, and a package substrate 1212 on an integrated circuit (IC) package 1204, which will be described in further detail below with respect to FIG. 12, the thick Cu plating of the conductive layer 422 can be used to reduce the number of Cu layers in the advanced node SOC wafer 100, or in the package substrate 1212, or both.

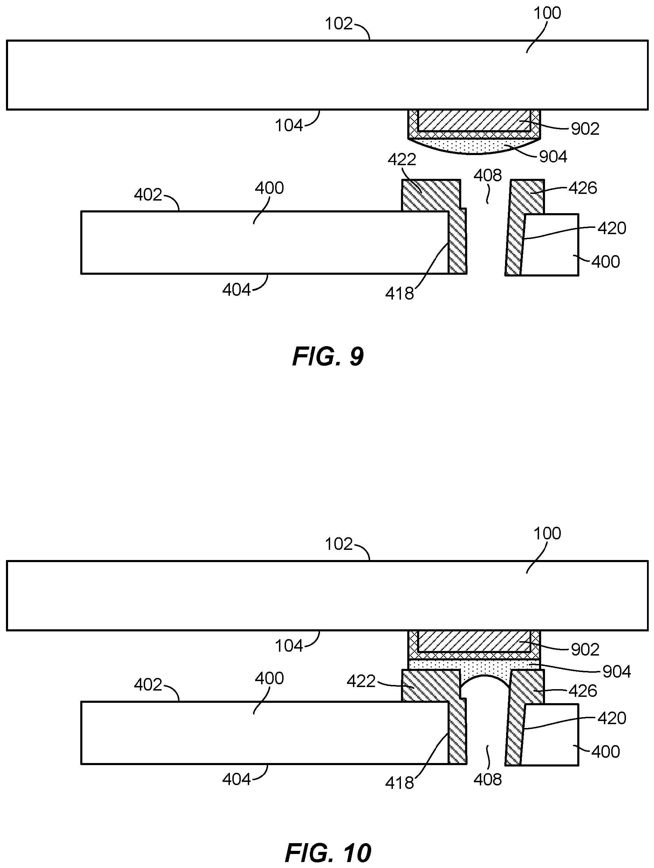

FIG. 9 is a sectional view illustrating an embodiment of a fifth process step in the manufacturing of a system-on-chip (SOC) device by joining an SOC wafer with an inductor wafer. In the embodiments, the SOC wafer 100 is provided with a plurality of metal columns, such as metal column 902 on the second surface 104 of the SOC wafer. In an embodiment, a solder 904 is provided on the metal column 902 for joining with a respective metal-plated via of the inductor wafer. In the sectional view illustrated in FIG. 9, the metal column 902 on the second surface 104 of the SOC wafer 100 is aligned with the via 408 in the inductor wafer 400, which is described above with respect to FIG. 7. For simplicity of illustration, the thin-film magnetic layer 410 and the dielectric layer 412 are omitted in the sectional view of FIG. 9.

FIG. 10 is a sectional view illustrating an embodiment of the SOC device of FIG. 9 after the SOC wafer and the inductor wafer are joined together. In the embodiment illustrated in FIG. 10, the solder 904 connects the top portions of conductors 422 and 426 over the sidewalls 418 and 420 of the via 408, respectively, and is positioned directly over the via 408 in the inductor wafer 400. In an embodiment, the solder 904 may comprise a conventional solder material that melts under heat and solidifies when the temperature cools down.

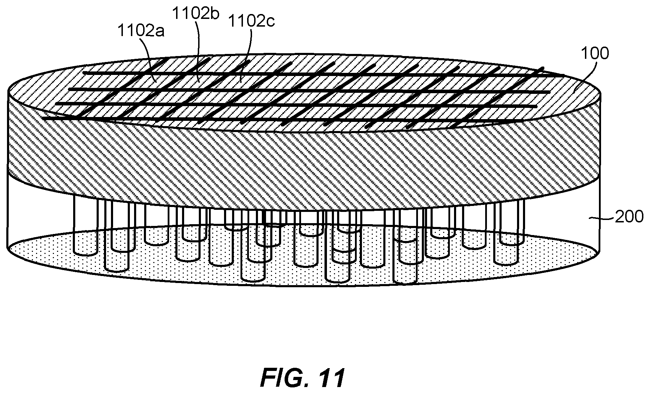

FIG. 11 is a perspective view illustrating an embodiment of an inductor die after dicing of the joined SOC wafer and inductor wafer. In typical wafer fabrication processes, multiple identical chips may be fabricated on a single wafer with a large surface area. In an embodiment, a chip may be separated from a wafer by one of many dicing techniques known to persons skilled in the art. In the embodiment shown in FIG. 11, the joined SOC wafer 100 and the inductor wafer 200 may be diced into a plurality of dies 1102a, 1102b, 1102c, .... Any one of the dies 1102a, 1102b, 1102c, ... includes one or more inductors and one or more other components, such as one or more capacitors, as part of an integrated or embedded voltage regulator.

FIG. 12 is a sectional view illustrating an embodiment of a system including a printed circuit board (PCB), an SOC package, and a voltage regulator which includes an inductor die. In FIG. 12, a printed circuit board (PCB) 1202 is provided, and an IC package 1204 is provided on the PCB 1202. In an embodiment, the IC package may include one or more analog integrated circuits, one or more digital integrated circuits, or a combination thereof. In an embodiment, the IC package 1204 may have one of various configurations known to persons skilled in the art, including but not limited to wirebond, flip-chip, or ball grid array (BGA), for example.

Referring to FIG. 12, a die 1206 that includes an inductor fabricated on an inductor wafer with through vias and joined with an SOC wafer in embodiments described above with respect to FIGs. 1-11 is integrated with the IC package 1204. In an embodiment, the IC package 1204 includes a package substrate 1212. In the embodiments, the die 1206 is provided as a part of the circuitry for an integrated or embedded voltage regulator 1208, which also includes other components. For example, the voltage regulator 1208 may include one or more additional passive components such as one or more capacitors. In FIG. 12, the rest of the circuitry for the voltage regulator 1208 are generically indicated by block 1210.

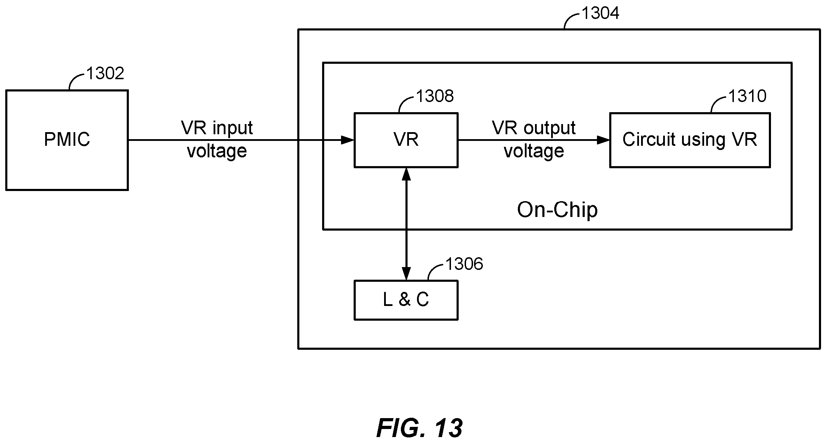

FIG. 13 is a simplified block diagram illustrating am embodiment of a system including a power management integrated circuit (PMIC) and an SOC device which includes an integrated or embedded voltage regulator and circuit using the voltage regulator. In the embodiment illustrated in FIG. 13, the PMIC 1302 is shown as a chip separate from the SOC device 1304. In an alternate embodiment, the PMIC 1302 may be integrated as part of the SOC device 1304. Referring to FIG. 13, the SOC device includes an inductor and capacitor (L & C) block 1306, a voltage regulator (VR) 1308, and one or more circuits 1310 using the output voltage from the VR 1308. In an embodiment, the inductor and capacitor in the L & C block 1306 may be integrated or embedded with the VR 1308 on the same chip as the circuits 1310 using the output voltage from the VR 1308 in an SOC device.

While the foregoing disclosure shows illustrative embodiments, it should be noted that various changes and modifications could be made herein. The functions, steps or actions of the method claims in accordance with embodiments described herein need not be performed in any particular order unless expressly stated otherwise. Furthermore, although elements may be described or claimed in the singular, the plural is contemplated unless limitation to the singular is explicitly stated.

## Claims

1. A device, comprising:
a system-on-chip, SOC, wafer (100) comprising an integrated voltage regulator;
an inductor wafer (400) having first (402) and second (404) surfaces and a plurality of vias (406, 408) therethrough, the vias (406, 408) forming a plurality of sidewalls (414, 416, 418, 420) in the inductor wafer (400), the first surface (402) of the inductor wafer (400) disposed adjacent to the SOC wafer (100);
a magnetic layer (410) on at least a portion of the first surface (402) of the inductor wafer (400);
a dielectric layer (412) disposed on the magnetic layer (410) and on at least a portion of the first surface (402) of the inductor wafer (400); and
a conductive layer (422) disposed on the dielectric layer (412), on at least a portion of the first surface (402) of the inductor wafer (400), on at least a portion of the second surface (404) of the inductor wafer (400), and on at least some of the sidewalls (414, 416, 418, 420) formed by the vias (406, 408) in the inductor wafer (400), the conductive layer thereby forming an inductor having opposite ends electrically connected with other components in the voltage regulator,
wherein the SOC wafer (100) has at least two metal columns (902) on a surface thereof, facing the first surface (402) of the inductor wafer (400) and aligned with corresponding vias (406, 408), for electrically connecting the conductive layer (422) to the SOC wafer (100).

2. The device of claim 1, wherein the magnetic layer (410) comprises a thin-film
magnetic layer.

3. The device of claim 1, wherein the conductive layer (422) comprises a copper
plating.

4. The device of claim 1, wherein the inductor wafer (400) comprises a glass wafer;
or
the inductor wafer (400) comprises a quartz wafer.

5. The device of any one of claims 1 to 4, comprising:
a plurality of conductors disposed within at least some of the vias (406, 408) in the inductor wafer (400), the conductors having respective first ends adjacent to the first surface (402) of the inductor wafer (400) and second ends adjacent to the second surface (404) of the inductor wafer (400), the conductors connecting with the conductive layer (422) on the dielectric layer (412), on at least a portion of the first surface (402) of the inductor wafer (400) and on at least a portion of the second surface (404) of the inductor wafer to form a coil.

6. The device of claim 5, wherein the coil at least partially surrounds the
magnetic layer (410).

7. A method of making a device, comprising:
providing an inductor wafer (400) having a first surface (402) and a second surface (404);
forming a plurality of vias (406, 408) through the first (402) and second (404) surfaces of the inductor wafer (400), the vias (406, 408) defined by a plurality of sidewalls (414, 416, 418, 420) within the inductor wafer (400);
forming a patterned magnetic layer (410) on at least a portion of the first surface (402) of the inductor wafer (400);
forming a dielectric layer (412) on the magnetic layer (410) and on at least a portion
of the first surface (402) of the inductor wafer (400);
forming a conductive layer (422) on the dielectric layer (412), at least a portion of the first surface (402) of the inductor wafer (400), at least a portion of the second surface (404) of the inductor wafer (400), and at least some of the sidewalls (414, 416, 418, 420) of the vias (406, 408) thereby forming an inductor having first and second ends; and
joining to the inductor wafer (400) a system-on-chip, SOC, wafer (100) comprising an integrated voltage regulator having other components in the voltage regulator and having at least two metal columns (902) on a surface thereof facing the first surface (402) of the inductor wafer (400) and aligned with corresponding vias (406, 408) at opposite ends of the inductor, the opposite ends electrically connected with the other components in the voltage regulator.

8. The method of claim 7, wherein forming the conductive layer (422) comprises
forming a semi-additive plating of copper.

9. The method of claim 8, wherein forming the patterned magnetic layer (410)
comprises sputtering a magnetic material on at least a portion of the first surface (402) of the inductor wafer (400).

## Patentansprüche

1. Eine Vorrichtung, die umfasst:
einen System-on-Chip- bzw. SOC-Wafer (100) mit einem integrierten Spannungsregler;
einen Wafers mit Induktivität bzw. Induktor-Wafer (400) mit einer ersten (402) und einer zweiten (404) Oberfläche und einer Vielzahl von Vias bzw. Durchkontaktierungen (406, 408) durch diese, wobei die Durchkontaktierungen (406, 408) eine Vielzahl von Seitenwänden (414, 416, 418, 420) in dem Induktor-Wafer (400) bilden, wobei die erste Oberfläche (402) des Induktor-Wafers (400) angrenzend an den SOC-Wafer (100) angeordnet ist;
eine magnetische Schicht (410) auf zumindest einem Teil der ersten Oberfläche (402) des Induktor-Wafers (400);
eine dielektrische Schicht (412), die auf der magnetischen Schicht (410) und auf zumindest einem Teil der ersten Oberfläche (402) des Induktor-Wafers (400) angeordnet ist; und
eine leitfähige Schicht (422), die auf der dielektrischen Schicht (412), auf zumindest einem Teil der ersten Oberfläche (402) des Induktor-Wafers (400), auf zumindest einem Teil der zweiten Oberfläche (404) des Induktor-Wafers (400) und auf zumindest einigen der Seitenwände (414, 416, 418, 420), die durch die Durchkontaktierungen (406, 408) in dem Induktor-Wafer (400) gebildet sind, angeordnet ist, wobei die leitfähige Schicht dadurch einen Induktor bzw. Induktivität bildet, dessen gegenüberliegende Enden mit anderen Komponenten in dem Spannungsregler elektrisch verbunden sind,
wobei der SOC-Wafer (100) zumindest zwei Metallholme (902) auf einer Oberfläche davon hat, die der ersten Oberfläche (402) des Induktor-Wafers (400) zugewandt sind und mit entsprechenden Durchkontaktierungen (406, 408) ausgerichtet sind, um die leitfähige Schicht (422) mit dem SOC-Wafer (100) elektrisch zu verbinden.

2. Die Vorrichtung gemäß Anspruch 1, wobei die magnetische Schicht (410) eine Dünnschicht-Magnetschicht umfasst.

3. Die Vorrichtung gemäß Anspruch 1, wobei die leitfähige Schicht (422) eine Kupferbeschichtung umfasst.

4. Die Vorrichtung gemäß Anspruch 1, wobei der Induktor-Wafer (400) einen Glaswafer umfasst; oder
der Induktor-Wafer (400) einen Quarzwafer umfasst.

5. Die Vorrichtung gemäß einem der Ansprüche 1 bis 4, die umfasst:
eine Vielzahl von Leitern, die in zumindest einigen der Durchkontaktierungen (406, 408) in dem Induktor-Wafer (400) angeordnet sind, wobei die Leiter jeweils erste Enden angrenzend an die erste Oberfläche (402) des Induktor-Wafers (400) und zweite Enden angrenzend an die zweite Oberfläche (404) des Induktor-Wafers (400) haben, wobei die Leiter mit der leitfähigen Schicht (422) auf der dielektrischen Schicht (412), auf zumindest einem Teil der ersten Oberfläche (402) des Induktor-Wafers (400) und auf zumindest einem Teil der zweiten Oberfläche (404) des Induktor-Wafers verbunden sind, um eine Spule zu bilden.

6. Die Vorrichtung gemäß Anspruch 5, wobei die Spule die magnetische Schicht (410) zumindest teilweise umgibt.

7. Verfahren zur Herstellung einer Vorrichtung, das umfasst:
Vorsehen eines Wafers mit Induktivität bzw. Induktor-Wafers (400) mit einer ersten Oberfläche (402) und einer zweiten Oberfläche (404);
Bilden einer Vielzahl von Durchkontaktierungen (406, 408) durch die erste (402) und die zweite (404) Oberfläche des Induktor-Wafers (400), wobei die Durchkontaktierungen (406, 408) durch eine Vielzahl von Seitenwänden (414, 416, 418, 420) innerhalb des Induktor-Wafers (400) definiert sind;
Bilden einer gemusterten magnetischen Schicht (410) auf zumindest einem Teil der ersten Oberfläche (402) des Induktor-Wafers (400);
Bilden einer dielektrischen Schicht (412) auf der magnetischen Schicht (410) und auf zumindest einem Teil der ersten Oberfläche (402) des Induktor-Wafers (400);
Bilden einer leitenden Schicht (422) auf der dielektrischen Schicht (412), zumindest einem Teil der ersten Oberfläche (402) des Induktor-Wafers (400), zumindest einem Teil der zweiten Oberfläche (404) des Induktor-Wafers (400) und zumindest einigen der Seitenwände (414, 416, 418, 420) der Durchkontaktierungen (406, 408), wodurch ein Induktor bzw. Induktivität mit einem ersten und einem zweiten Ende gebildet wird; und
Anfügen an den Induktor-Wafer (400) eines System-on-Chip- bzw. SOC-Wafers (100) mit einem integrierten Spannungsregler, der andere Komponenten in dem Spannungsregler hat und zumindest zwei Metallholme (902) auf einer Oberfläche davon hat, die der ersten Oberfläche (402) des Induktor-Wafers (400) zugewandt sind und mit entsprechenden Durchkontaktierungen (406, 408) an gegenüberliegenden Enden des Induktors ausgerichtet sind, wobei die gegenüberliegenden Enden mit den anderen Komponenten in dem Spannungsregler elektrisch verbunden sind.

8. Das Verfahren gemäß Anspruch 7, wobei das Bilden der leitfähigen Schicht (422) ein Bilden einer semiadditiven Kupferbeschichtung umfasst.

9. Das Verfahren gemäß Anspruch 8, wobei das Bilden der gemusterten magnetischen Schicht (410) ein Aufsprühen eines magnetischen Materials auf zumindest einen Teil der ersten Oberfläche (402) des Induktor-Wafers (400) umfasst.

## Revendications

1. Dispositif, comprenant :
une plaquette de système sur puce, SOC, (100) comprenant un régulateur de tension intégré ;
une plaquette d'inducteur (400) comportant des première (402) et seconde (404) surfaces et une pluralité de trous de liaison (406, 408) à travers celles-ci, les trous de liaison (406, 408) formant une pluralité de parois latérales (414, 416, 418, 420) dans la plaquette d'inducteur (400), la première surface (402) de la plaquette d'inducteur (400) étant disposée adjacente à la plaquette SOC (100) ;
une couche magnétique (410) sur au moins une partie de la première surface (402) de la plaquette d'inducteur (400) ;
une couche diélectrique (412) disposée sur la couche magnétique (410) et sur au moins une partie de la première surface (402) de la plaquette d'inducteur (400) ; et
une couche conductrice (422) disposée sur la couche diélectrique (412), sur au moins une partie de la première surface (402) de la plaquette d'inducteur (400), sur au moins une partie de la seconde surface (404) de la plaquette d'inducteur (400) et sur au moins certaines des parois latérales (414, 416, 418, 420) formées par les trous de liaison (406, 408) dans la plaquette d'inducteur (400), la couche conductrice formant ainsi un inducteur comportant des extrémités opposées connectées électriquement à d'autres composants du régulateur de tension,
la plaquette SOC (100) comportant au moins deux colonnes métalliques (902) sur une surface de celle-ci, faisant face à la première surface (402) de la plaquette d'inducteur (400) et alignées avec des trous de liaison (406, 408) correspondants, pour connecter électriquement la couche conductrice (422) à la plaquette SOC (100).

2. Dispositif selon la revendication 1, dans lequel la couche magnétique (410) comprend une couche magnétique en couches minces.

3. Dispositif selon la revendication 1, dans lequel la couche conductrice (422) comprend un placage au cuivre.

4. Dispositif selon la revendication 1, dans lequel la plaquette d'inducteur (400) comprend une plaquette de verre ; ou
la plaquette d'inducteur (400) comprend une plaquette de quartz.

5. Dispositif selon l'une quelconque des revendications 1 à 4, comprenant :
une pluralité de conducteurs disposés à l'intérieur d'au moins certains des trous de liaison (406, 408) dans la plaquette d'inducteur (400), les conducteurs comportant des premières extrémités respectives adjacentes à la première surface (402) de la plaquette d'inducteur (400) et des secondes extrémités adjacentes à la seconde surface (404) de la plaquette d'inducteur (400), les conducteurs se connectant à la couche conductrice (422) sur la couche diélectrique (412), sur au moins une partie de la première surface (402) de la plaquette d'inducteur (400) et sur au moins une partie de la seconde surface (404) de la plaquette d'inducteur pour former une bobine.

6. Dispositif selon la revendication 5, dans lequel la bobine entoure au moins en partie la couche magnétique (410).

7. Procédé de fabrication d'un dispositif, comprenant les étapes consistant à :
fournir une plaquette d'inducteur (400) comportant une première surface (402) et une seconde surface (404) ;
former une pluralité de trous de liaison (406, 408) à travers les première (402) et seconde (404) surfaces de la plaquette d'inducteur (400), les trous de liaison (406, 408) étant définis par une pluralité de parois latérales (414, 416, 418, 420) à l'intérieur de la plaquette d'inducteur (400) ;
former une couche magnétique (410) à motifs sur au moins une partie de la première surface (402) de la plaquette d'inducteur (400) ;
former une couche diélectrique (412) sur la couche magnétique (410) et sur au moins une partie de la première surface (402) de la plaquette d'inducteur (400) ;
former une couche conductrice (422) sur la couche diélectrique (412), sur au moins une partie de la première surface (402) de la plaquette d'inducteur (400), sur au moins une partie de la seconde surface (404) de la plaquette d'inducteur (400) et sur au moins certaines des parois latérales (414, 416, 418, 420) des trous de liaison (406, 408), de manière à former un inducteur comportant des première et seconde extrémités ; et
joindre à la plaquette d'inducteur (400) une plaquette de système sur puce,
SOC, (100) comprenant un régulateur de tension intégré comportant d'autres composants dans le régulateur de tension et comportant au moins deux colonnes métalliques (902) sur une surface de celui-ci faisant face à la première surface (402) de la plaquette d'inducteur (400) et alignées avec des trous de liaison (406, 408) correspondants au niveau d'extrémités opposées de l'inducteur, les extrémités opposées étant connectées électriquement aux autres composants dans le régulateur de tension.

8. Procédé selon la revendication 7, dans lequel la formation de la couche conductrice (422) comprend l'étape consistant à former un placage au cuivre semi-additif.

9. Procédé selon la revendication 8, dans lequel la formation de la couche magnétique (410) à motifs comprend l'étape consistant à pulvériser un matériau magnétique sur au moins une partie de la première surface (402) de la plaquette d'inducteur (400).
